Europäisches Patentamt

European Patent Office

Office européen des brevets

(19)

(11) **EP 0 755 461 B1**

(12) **EUROPÄISCHE PATENTSCHRIFT**

(45) Veröffentlichungstag und Bekanntmachung des Hinweises auf die Patenterteilung:
**05.11.1997 Patentblatt 1997/45**

(21) Anmeldenummer: **95915754.6**

(22) Anmeldetag: **07.04.1995**

(51) Int Cl.6: **C23C 14/32**, H01J 37/32

(86) Internationale Anmeldenummer:
**PCT/DE95/00476**

(87) Internationale Veröffentlichungsnummer:
**WO 95/28508 (26.10.1995 Gazette 1995/46)**

(54) **VERFAHREN UND EINRICHTUNG FÜR DIE IONENGESTÜTZTE VAKUUMBESCHICHTUNG**

PROCESS AND DEVICE FOR ION-SUPPORTED VACUUM COATING

PROCEDE ET DISPOSITIF DE REVETEMENT PAR EVAPORATION SOUS VIDE PAR VOIE IONIQUE

(84) Benannte Vertragsstaaten:
**AT BE CH DK FR GB IT LI NL**

(30) Priorität: **14.04.1994 DE 4412906**

(43) Veröffentlichungstag der Anmeldung:
**29.01.1997 Patentblatt 1997/05**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
- NEUMANN, Manfred
  D-01277 Dresden (DE)
- GOEDICKE, Klaus
  D-01307 Dresden (DE)
- SCHILLER, Siegfried
  D-01324 Dresden (DE)
- RESCHKE, Jonathan
  D-01067 Dresden (DE)
- MORGNER, Henry
  D-01257 Dresden (DE)
- MILDE, Falk
  D-01109 Dresden (DE)
- FIETZKE, Fred
  D-01129 Dresden (DE)

(56) Entgegenhaltungen:
US-A- 3 900 585          US-A- 5 242 561

- PATENT ABSTRACTS OF JAPAN vol. 007 no. 167 (C-177) ,22.Juli 1958 & JP,A,58 073765 (AYAO WADA) 4.Mai 1983,
- PATENT ABSTRACTS OF JAPAN vol. 006 no. 102 (C-107) ,11.Juni 1982 & JP,A,57 032367 (JEOL LTD) 22.Februar 1982,
- PATENT ABSTRACTS OF JAPAN vol. 018 no. 201 (C-1188) ,8.April 1994 & JP,A,06 002119 (SAKAE DENSHI KOGYO KK;OTHERS: 03) 11.Januar 1994,
- PATENT ABSTRACTS OF JAPAN vol. 012 no. 301 (C-521) ,16.August 1988 & JP,A,63 076871 (HITACHI LTD) 7.April 1988,

**Beschreibung**

Die Erfindung betrifft ein Verfahren und die zugehörige Einrichtung für die ionengestützte Vakuumbeschichtung elektrisch leitfähiger oder elektrisch isolierender Substrate mit elektrisch isolierenden Schichten und elektrisch isolierender Substrate mit elektrisch leitfähigen Schichten. Ein bevorzugtes Anwendungsgebiet ist die ionengestützte Vakuumbeschichtung von Kunststoffolien mit elektrisch isolierenden Oxidschichten. Von besonderer Bedeutung ist das Abscheiden von Verschleißschutzschichten und Korrosionsschutzschichten sowie von Barriereschichten für Verpakkungszwecke.

Es ist bekannt, daß durch ionengestützte Vakuumbeschichtung eine höhere Packungsdichte und damit eine größere Härte und bessere Barriereeigenschaften der aufwachsenden Schicht erzielt werden kann.

Eine Variante der ionengestützten Vakuumbeschichtung besteht darin, zusätzlich zur Beschichtungsquelle eine Ionenquelle in der Beschichtungskammer anzuordnen, so daß gleichzeitig mit den Atomen bzw. Molekülen des Schichtmaterials Edelgas- bzw. Reaktivgasionen auf das Substrat auftreffen. Durch den Ionenbeschuß werden locker sitzende Schichtbestandteile durch Stoßprozesse von der Schichtoberfläche entfernt oder in energetisch günstigere Positionen befördert. Beim Abscheiden von Schichten aus chemischen Verbindungen, beispielsweise Oxiden, kann durch den Beschuß mit Reaktivgasionen, beispielsweise mit Sauerstoffionen, außer der Packungsdichte auch die Stöchiometrie der Schichten verbessert werden. Beim Beschichten elektrisch isolierender Substrate bzw. beim Abscheiden elektrisch isolierender Schichten ist es erforderlich, den Ionenstrahl durch Beimischen von Elektronen zu neutralisieren, damit sich die Schicht nicht elektrisch auflädt. Zu diesem Zweck werden die Ionenquellen mit geeigneten Neutralisatoren ausgerüstet.

Für die ionengestützte Beschichtung mit hohen Beschichtungsraten, wie sie beispielsweise für die Beschichtung von Kunststoffolien oder Metallband in Bandbeschichtungsanlagen benötigt werden, sind die bisher verfügbaren Ionenquellen ungeeignet. Zum einen sind die den hohen Beschichtungsraten angepaßten hohen Ionenströme mit vertretbarem Aufwand nicht realisierbar. Zum anderen entspricht die wartungsfreie Einsatzdauer der Ionenquellen infolge der hohen Dampfdichten und der damit verbundenen hohen Verschmutzungsraten nicht den Anforderungen des industriellen Einsatzes.

Es ist bekannt, zum Vermeiden dieser Nachteile die ionengestützte Beschichtung auch ohne Einsatz separater Ionenquellen zu realisieren. Zu diesem Zweck werden durch verschiedene Mittel Ionen zwischen Beschichtungsquelle und Substrat erzeugt und durch Anlegen einer negativen Bias-Spannung an das Substrat auf dieses beschleunigt. Das Erzeugen der Ionen kann durch eine selbständige oder unselbständige Glimmentladung, eine Bogenentladung oder - beim Beschichten durch Hochratezerstauben - durch eine Magnetronentladung erfolgen. Das Beschleunigen der Ionen auf das Substrat durch Anlegen einer negativen Bias-Spannung ist jedoch nur möglich, wenn es sich um das Abscheiden elektrisch leitfähiger Schichten auf elektrisch leitfähigen Substraten handelt (Vakuumbeschichtung Bd. 4, G. Kienel, VDI-Verlag Düsseldorf, 1993, S. 33).

Es ist bekannt, daß sich isolierende Substrate bzw. isolierende Schichten von selbst auf eine geringe negative Bias-Spannung in der Größenordnung von -10 V aufladen, wenn man in unmittelbarer Nähe der Substratoberfläche ein Plasma hoher Dichte erzeugt. Diese sogenannte Selbst-Bias-Spannung und die daraus resultierenden Ionenenergien sind jedoch zu gering, um die gewünschte Strukturverbesserung und insbesondere die erhöhte Packungsdichte der abgeschiedenen Schichten zu bewirken.

Es ist weiterhin bekannt, diese Selbst-Bias-Spannung beim Beschichten isolierender Substrate bzw. beim Abscheiden isolierender Schichten dadurch zu erhöhen, daß senkrecht zur Substratoberfläche ein hochfrequentes elektrisches Wechselfeld zur Einwirkung gebracht wird. Oberhalb einer sogenannten Cut-off-Frequenz, die in Abhängigkeit von Geometrie und Wechselfeldamplitude bei einigen Megahertz liegt, werden die Elektronen des Plasmas zu intensiven Schwingungen angeregt, während die Ionen infolge ihrer größeren Masse der hohen Frequenz nicht folgen können. Das Ergebnis ist eine verstärkte Ionisierung des Plasmas und eine von Geometrie und Wechselfeldamplitude abhängige negative Aufladung der Substrat- bzw. Schichtoberfläche. Es ist üblich, diese Hochfrequenz-Anregung bei der für industrielle Anwendungen freigegebenen Frequenz von 13,56 MHz durchzuführen.

Die Anwendung derart hoher Frequenzen ist jedoch mit erheblichem technischen Aufwand verbunden und daher aus ökonomischen Gründen auf relativ kleine Substratflächen begrenzt. Typische Anwendungen sind die Beschichtung optischer Bauteile und elektronischer Bauelemente. Für die Übertragung der Hochfrequenzleistung sind Anpaßnetzwerke erforderlich, deren Verlustleistung mit der Kapazität der Hochfrequenzelektroden, d. h. mit der Substratgröße, stark ansteigt. Beim Beschichten von Kunststoffolien muß beispielsweise die gesamte Kühlwalze, über die die Folie während der Beschichtung geführt wird, als Hochfrequenzelektrode ausgebildet werden. Bei Beschichtungsbreiten in der Größenordnung von einem Meter oder mehr ist der erforderliche Aufwand für Hochfrequenzgenerator und Anpaßnetzwerk ökonomisch nicht mehr vertretbar.

Schließlich ist es auch bekannt, elektrisch nicht oder schlecht leitende Substrate ionengestützt zu beschichten. Dazu sind im Plasmaraum zwischen der Dampfquelle und dem zu beschichtenden Substrat Elektroden angeordnet, die an Wechselspannung angeschlossen sind. Die Frequenz dieser Wechselspannung liegt zwischen einigen kHz und einigen 100 kHz, wobei die Spannung + 250 V relativ zum Plasmapotential von - 800 V beträgt. Die Glühkatode emittiert dabei ständig gleichmäßig Elektronen (DD 161 137 A 3). Dieses Verfahren bzw. die zugehörige Einrichtung haben den Nachteil, daß die erzeugten Schichten nur eine geringe Packungsdichte aufweisen, so daß die Qualität der Schichten, insbesondere auf Kunststoffolien, nicht den hohen Anforderungen entspricht, die an Korrosionsschutz- und Barriereschichten gestellt werden.

Außerdem ist der Aufwand zur Erzeugung der hohen Frequenzen relativ hoch.

Der Erfindung liegt die Aufgabe zugrunde, ein Verfahren und eine Einrichtung für die ionengestützte Vakuumbeschichtung zu finden, die die Hochratebeschichtung großflächiger elektrisch leitfähiger oder elektrisch isolierender Substrate mit elektrisch isolierenden Schichten und elektrisch isolierender Substrate mit elektrisch leitfähigen Schichten bei ökonomisch vertretbarem und möglichst geringem Aufwand gestattet. Insbesondere sollen Kunststoffolien oder andere bandförmige Materialien mit einer Breite von über einem Meter kostengünstig beschichtet werden können. Der apparative Aufwand der Einrichtung soll den sonst üblichen nicht wesentlich übersteigen.

Die Aufgabe wird erfindungsgemäß nach den Merkmalen des Patentanspruches 1 gelöst. In den Unteransprüchen 2 bis 9 sind weitere vorteilhafte Ausgestaltungen des erfindungsgemäßen Verfahrens beschrieben. Die Einrichtung zur Durchführung des Verfahrens ist in den Patentansprüchen 10 bis 22 beschrieben.

Die Beschleunigung von Ionen aus dem zwischen Beschichtungsquelle und Substrat erzeugten Plasma in Richtung auf das isolierende Substrat bzw. die isolierende Schicht ist erfindungsgemäß auch ohne die Selbst-Bias-Erzeugung mittels eines aufwendigen Hochfrequenzfeldes möglich, wenn im Falle leitfähiger Substrate an das Substrat oder im Falle isolierender Substrate an eine unmittelbar hinter dem Substrat angeordnete Elektrode abwechselnd negative und positive Spannungsimpulse relativ zum Plasmapotential angelegt werden und die Dauer der Impulse an die Aufladezeit des Kondensators angepaßt wird, der durch die isolierende Schicht bzw. das isolierende Substrat gebildet wird. Die an der Rückseite der isolierenden Schicht bzw. des isolierenden Substrates angelegten Spannungsimpulse werden wie bei einem Kondensator auf die dem Plasma zugewandte Oberfläche der isolierenden Schicht bzw. des isolierenden Substrates übertragen, solange kein Stromfluß vom Plasma auf diese Oberfläche erfolgt. Dadurch wird abwechselnd eine negative und eine positive Bias-Spannung an der dem Plasma zugewandten isolierenden Oberfläche des Substrates bzw. der Schicht erzeugt. Während des negativen Spannungsimpulses werden positive Ionen und während des positiven Spannungsimpulses werden Elektronen aus dem Plasma auf die Oberfläche des Substrates bzw. der Schicht beschleunigt. Durch den damit verbundenen Ionen- bzw. Elektronenstrom wird jedoch nach kurzer Zeit der durch das isolierende Substrat und/oder die isolierende Schicht gebildete Kondensator aufgeladen. Die dem Plasma zugewandte Oberfläche nimmt dann das Plasmapotential an, und es können keine weiteren Ionen bzw. Elektronen mehr aus dem Plasma abgesaugt werden. Durch das Abwechseln negativer und positiver Spannungsimpulse, die unmittelbar aneinander anschließen und deren Länge an die Aufladezeit des durch das isolierende Substrat und/oder die isolierende Schicht gebildeten Kondensators angepaßt wird, erhält man unmittelbar aneinander anschließende Ionen- und Elektronenströme auf die Substrat- bzw. Schichtoberfläche. Dabei hat sich gezeigt, daß bei Plasmadichten von etwa $10^{10}$ cm$^{-3}$ die Dauer der negativen Impulse in der Größenordnung von 1 ms für isolierende Schicht- bzw. Substratdicken von etwa 1 µm und in der Größenordnung von 10 µs für isolierende Schicht- bzw. Substratdicken von etwa 100 µm liegen sollte. Die Dauer der positiven Impulse kann wegen der im Vergleich zu den Ionen höheren Beweglichkeit der Elektronen kürzer als die Dauer der negativen Impulse sein. Eine um den Faktor 2 bis 10 geringere Dauer der positiven Impulse ist bezüglich der Zeitausnutzung ausreichend und bezüglich des technischen Aufwandes relativ einfach realisierbar.

Damit ergeben sich zweckmäßige Impulsfolgefrequenzen von etwa 1 kHz für etwa 1 µm dicke Isolierschichten auf leitfähigen Substraten bzw. von etwa 100 kHz für isolierende oder leitfähige Schichten auf etwa 100 µm dicken isolierenden Substraten. Derartige Frequenzen sind im Gegensatz zu der bekannten Hochfrequenz-anregung bei 13,56 MHz mit wesentlich kostengünstigeren Generatoren und ohne aufwendige Anpaßglieder zu realisieren. Ein weiterer Vorteil des erfindungsgemäßen Verfahrens mit abwechselnder positiver und negativer Bias-Spannung im Mittel frequenzbereich gegenüber der kontinuierlichen negativen Selbst-Bias-Spannung bei Hochfrequenzanregung besteht darin, daß Spannungsdurchschläge und Microarcs, die für Bias-Spannungen oberhalb von 1000 V insbesondere bei dünnen isolierenden Schichten oder dünnen isolierenden Substraten auftreten können, durch den Polaritätswechsel im Mittelfrequenzbereich nicht auftreten bzw. im unterkritischen Zustand erlöschen.

Es ist zweckmäßig, für die Durchführung des erfindungsgemäßen Verfahrens rechteckförmige Spannungsimpulse zu verwenden, wobei die Anstiegs- und Abfallzeiten der Impulse durch entsprechende Beschaltung dem Verfahren optimal angepaßt werden sollten. Die Abfallzeit der negativen Impulse und die daran anschließende Anstiegszeit der positiven Impulse sollte so groß gewählt werden, daß das Oberflächenpotential der isolierenden Schicht zu keinem Zeitpunkt um mehr als 20 V positiv gegenüber dem Plasmapotential angehoben wird. Das wird erreicht, wenn der positive Spannungsanstieg höchstens genauso schnell oder langsamer eingestellt wird, als die negative Aufladung der isolierenden Schichtoberfläche durch Elektronen aus dem Plasma erfolgt. Durch diese Maßnahme wird erreicht, daß die Elektronen mit einer möglichst geringen Bias-Spannung beschleunigt werden und das Substrat nicht unnötig mit zusätzlicher Energie belasten. Dagegen sollte die Abfallzeit der positiven Impulse und die daran anschließende Anstiegzeit der negativen Impulse möglichst kurz sein, damit die gewünschte negative Biasspannung an der Substrat- bzw. Schichtoberfläche erreicht wird und nicht schon während des negativen Spannungsanstiegs durch den Ionenstrom aus dem Plasma reduziert wird. Der negative Spannungsanstieg muß um so schneller erfolgen, je höher die Teilchendichte des Plasmas und je höher demzufolge der Ionenstrom auf die Substrat- bzw. Schichtoberfläche ist.

Bei Anwendungen mit geringerer Plasmadichte ist ein langsamerer negativer Spannungsanstieg zulässig und es können statt der rechteckförmigen Spannungsimpulse kostengünstiger zu erzeugende sinusförmige Spannungsimpulse verwendet werden. Dabei muß die Frequenz so hoch gewählt werden, daß ausreichend hohe negative Bias-Impulse an der Substrat- bzw. Schichtoberfläche erreicht werden.

Eine besonders vorteilhafte Anwendung des erfindungsgemäßen Verfahrens besteht in der ionengestützten Beschichtung leitfähiger Substrate mit dünnen isolierenden Schichten. Dünne isolierende Schichten bis zu wenigen μm Dicke bilden zwischen dem leitfähigen Substrat und dem Plasma einen Kondensator mit hoher Kapazität und hoher Aufladungszeit und benötigen daher nur relativ kleine und kostengünstig realisierbare Impuls-Folgefrequenzen. Darüber hinaus neigen dünne isolierende Schichten bei ionengestützter Beschichtung mit Hochfrequenzanregung stark zu Spannungsdurchschlägen und Mikrolichtbögen, so daß die Anwendung des erfindungsgemäßen Verfahrens die nahezu einzige Möglichkeit für eine stabile und defektarme ionengestützte Beschichtung darstellt.

Eine weitere vorteilhafte Anwendung des Verfahrens ergibt sich bei der ionengestützten Beschichtung dünner Kunststoffolien mit isolierenden oder leitfähigen Schichten. Derart beschichtete Kunststoffolien werden beispielsweise als Barrierefolien in der Verpackungsindustrie benötigt, die minimale Herstellungskosten erfordern. Die interessierenden Dicken der Kunststoffolien betragen dabei 10-20 μm, so daß auch in diesem Fall das erfindungsgemäße Verfahren mit relativ geringen Impulsfolgefrequenzen zum Einsatz kommen kann.

Eine besonders günstige Gestaltung des erfindungsgemäßen Verfahrens ergibt sich, wenn als Beschichtungsquelle ein Elektronenstrahlverdampfer verwendet wird. In diesem Falle wird bereits durch den Elektronenstrahl und durch rückgestreute Elektronen ein Plasma erzeugt, und eine separate Plasmaquelle ist oftmals nicht erforderlich.

Für das Abscheiden besonders hochwertiger Schichten bzw. für die Realisierung besonders hoher Beschichtungsraten werden jedoch höhere Plasmadichten benötigt. In diesem Falle ist es zweckmäßig, die erforderlichen hohen Plasmadichten durch Niedervolt-Bogenentladungen, insbesondere durch Hohlkatoden-Bogenentladungen, zu erzeugen. Kommt es dagegen besonders auf eine hohe Homogenität der Beschichtung über große Beschichtungsbreiten an, dann ist es vorteilhaft, das Plasma durch eine an sich bekannte Magnetronentladung zwischen zwei mit zeitlich wechselnder Polarität gegeneinander brennenden Puls-Magnetrons zu erzeugen.

Eine besonders vorteilhafte Lösung ergibt sich dann, wenn die Beschichtung allein oder zusätzlich zum Bedampfen durch eine oder mehrere Zerstäubungsquellen erfolgt. In diesem Falle ist keine separate Plasmaquelle erforderlich, und durch die Kombination der Beschichtung durch Zerstäuben mit dem erfindungsgemäßen alternierenden Mittelfrequenz-Impuls-Bias erhält man besonders hochwertige Schichten. Als Zerstäubungsquellen kommen reaktiv betriebene Gleichspannungs-Magnetrons oder Hochfrequenz-Magnetrons in Betracht. Besonders fehlstellenarme Schichten erhält man bei Verwendung der bereits genannten Puls-Magnetrons als Beschichtungsquelle.

Die zweckmäßigste Einrichtung zur Durchführung des erfindungsgemäßen Verfahrens ist eine an sich bekannte Vakuumbeschichtungsanlage, die mit einer Beschichtungsquelle, einer Substrathalterung bzw. -führungseinrichtung und mit Mitteln zur Erzeugung eines Plasmas ausgerüstet ist. Zusätzlich ist eine Spannungsquelle zur Erzeugung von Spannungsimpulsen wechselnder Polarität mit Impulshöhen zwischen ± 20 V und ± 2000 V und Impulsdauern zwischen 1 μs und 1000 μs erforderlich. Ein Pol dieser Spannungsquelle wird mit einer annähernd auf Plasmapotential befindlichen Elektrode und der andere Pol wird im Fall leitfähiger Substrate mit dem gegen das Plasma isolierten Substrat und im Fall isolierender Substrate mit einer unmittelbar hinter dem Substrat angeordneten und sich über die gesamte Beschichtungsfläche erstreckenden Elektrode verbunden.

Bei der Beschichtung dünner isolierender Kunststoffolien kann die üblicherweise zur Führung und Kühlung der Kunststoffolie in der Beschichtungszone vorgesehene Kühlwalze als unmittelbar hinter dem Substrat angeordnete Elektrode verwendet werden. Allerdings ist dann diese Kühlwalze im Gegensatz zu üblichen Folienbeschichtungsanlagen gegen Massepotential zu isolieren und ggf. mit Abschirmungen gegen das Zünden parasitärer Glimmentladungen zu versehen.

Bei Einrichtungen mit Elektronenstrahlverdampfern als Beschichtungsquelle ist es zweckmäßig, zwischen Verdampfungsgut und Substrat eine an sich bekannte Magnetfalle anzuordnen. Dadurch werden die am Verdampfungsgut rückgestreuten Elektronen auf Kreisbahnen gezwungen, so daß sich ihr Weg und damit ihre Ionisierungswahrscheinlichkeit in Dampf und Restgas erhöht und auch ohne zusätzliche Plasmaquelle eine für das erfindungsgemäße Verfahren ausreichende Plasmadichte erreicht wird.

Für das Erzeugen besonders hoher Ionenstromdichten am Substrat ist es zweckmäßig, Niedervolt-Bogenquellen als zusätzliche Plasmaquellen zwischen Beschichtungsquelle und Substrat anzuordnen. Besonders eignen sich Hohlkatoden-Bogenquellen. Bei Verwendung wechselstrombeheizter Verdampferschiffchen als Beschichtungsquelle in Verbindung mit Hohlkatoden-Bogenquellen ergibt sich als besonderer Vorteil eine seitliche Wechselablenkung der Hohlkatodenbögen durch die magnetischen Streufelder der wechselstrombeheizten Verdampferschiffchen. Das gilt insbesondere bei Verwendung eines an sich bekannten magnetischen Führungsfeldes parallel zu den Hohlkatodenbögen. Dadurch wird eine höhere Gleichmäßigkeit des Plasmas quer zu den Hohlkatodenbögen erreicht.

Eine weitere Erhöhung der Gleichmäßigkeit, insbesondere bei Verwendung von nur einer Hohlkatoden-Bogenquelle für mehrere Schiffchenverdampfer, wird durch Anordnung an sich bekannter magnetischer Ablenksysteme an den Hohlkatoden-Bogenquellen erreicht, die eine zusätzliche horizontale Wechselablenkung der Hohlkatodenbögen bewirken.

Eine weitere Ausgestaltung der erfindungsgemäßen Einrichtung ergibt sich bei Verwendung von zwei Puls-Magnetrons mit zeitlich wechselnder Polarität als Plasmaquellen. In diesem Falle kann die Puls-Spannungsquelle für die beiden Puls-Magnetrons gleichzeitig als Spannungsquelle für das erfindungsgemäße Puls-Bias verwendet werden. Die einfachste Lösung besteht darin, eine elektrische Verbindung zwischen einem der beiden Puls-Magnetrons und dem Substrat bzw. der unmittelbar hinter dem Substrat angeordneten Elektrode herzustellen. Da sich das Plasmapotential entsprechend der angelegten Puls-Spannung periodisch relativ zu jedem der beiden Puls-Magnetrons ändert, erhält man die gleiche periodische Pulsspannung auch zwischen dem Plasma und dem Substrat. Erhält das mit dem Substrat verbundene Magnetron einen positiven Impuls, dann werden Elektronen aus dem Plasma zum Substrat beschleunigt. Erhält es einen negativen Impuls, dann werden Ionen zum Substrat beschleunigt.

Eine andere Variante besteht darin, daß die Puls-Spannungsquelle aus zwei in Reihe geschalteten, synchron und gleichsinnig arbeitenden Spannungsquellen besteht und daß zwischen diesen beiden Pulsgeneratoren ein Spannungsabgriff vorhanden ist, der mit dem Substrat bzw. mit der unmittelbar hinter dem Substrat angeordneten Elektrode verbunden ist. In diesem Falle erhält man im Vergleich zur erstgenannten Variante bei gleicher Magnetron-Pulsspannung nur die halbe Pulsspannung zwischen Plasma und Substrat. Dafür verdoppelt sich die Pulsfrequenz am Substrat. Immer wenn an einem der beiden Magnetrons das Maximum der positiven Pulsspannung erreicht ist, werden Ionen vom Plasma zum Substrat beschleunigt. Während des Umpolens der beiden Magnetrons verschiebt sich das Plasmapotential kurzzeitig in negative Richtung, so daß kurzzeitig ein Elektronenstrom auf das Substrat fließt. Eine ähnliche Variante ergibt sich, wenn nur eine Puls-Spannungsquelle für die beiden Puls-Magnetrons vorgesehen ist und die beiden Ausgänge der Puls-Spannungsquelle über gleichgroße elektrische Widerstände mit dem Substrat bzw. der unmittelbar hinter dem Substrat angeordneten Elektrode verbunden sind. In diesem Falle erhält man die gleichen Potentialverhältnisse wie im vorgenannten Fall, benötigt aber insgesamt nur eine Puls-Spannungsquelle.

Eine ähnliche Ausgestaltung der erfindungsgemäßen Einrichtung ergibt sich bei Verwendung von Zerstäubungsquellen als alleinige Beschichtungsquelle oder zusätzlich zu beliebig beheizten Verdampferquellen. In diesem Falle dienen die Zerstäubungsquellen gleichzeitig als Beschichtungsquelle und als Plasmaquelle. Bei Verwendung von Gleichspannungs- oder Hochfrequenz-Magnetrons als Zerstäubungsquellen werden separate Spannungsquellen für den Betrieb der Magnetrons und die Erzeugung der Spannungsimpulse zwischen Plasma und Substrat verwendet. Als annähernd auf Plasmapotential befindliche Elektroden dienen dabei die elektrisch miteinander verbundenen Targets der Magnetrons. Bei Verwendung von Puls-Magnetrons als Zerstäubungsquellen kann die Puls-Spannungsquelle für die Puls-Magnetrons gleichzeitig als Puls-Spannungsquelle zur Erzeugung der Spannungsimpulse zwischen Plasma und Substrat benutzt werden. Dabei lassen sich die gleichen Varianten nutzen, die bei Verwendung von Puls-Magnetrons als Plasmaquelle beschrieben wurden.

Anhand einiger Ausführungsbeispiele wird die Erfindung näher erläutert. In den zugehörigen Zeichnungen zeigen:

Fig. 1 eine Einrichtung zur Durchführung des Verfahrens als Prinzipdarstellung,
Fig. 2 einen zeitlichen Verlauf der Potentiale und Ströme bei der Durchführung des Verfahrens,
Fig. 3 eine Einrichtung zur Beschichtung von Kunststoffolien mit einem Elektronenstrahlverdampfer als Beschichtungsquelle und einer Hohlkatoden-Bogenquelle als Plasmaquelle,
Fig. 4 eine Draufsicht auf eine Einrichtung zur Beschichtung von Kunststoffolien mit Schiffchenverdampfern als Beschichtungsquelle und Hohlkatoden-Bogenquellen als Plasmaquellen,
Fig. 5 eine Einrichtung zur Beschichtung von Kunststoffolien mit Schiffchenverdampfern als Beschichtungsquelle und Pulsmagnetrons als Plasmaquelle,
Fig. 5a eine Ausführung der Einrichtung nach Fig. 5 mit zwei Spannungsquellen,
Fig. 5b eine Ausführung der Einrichtung nach Fig. 5 mit einem Spannungsteiler,
Fig. 6 eine Einrichtung zur Beschichtung von Kunststoffolien mit zwei Pulsmagnetrons als Beschichtungsquelle und Plasmaquelle.

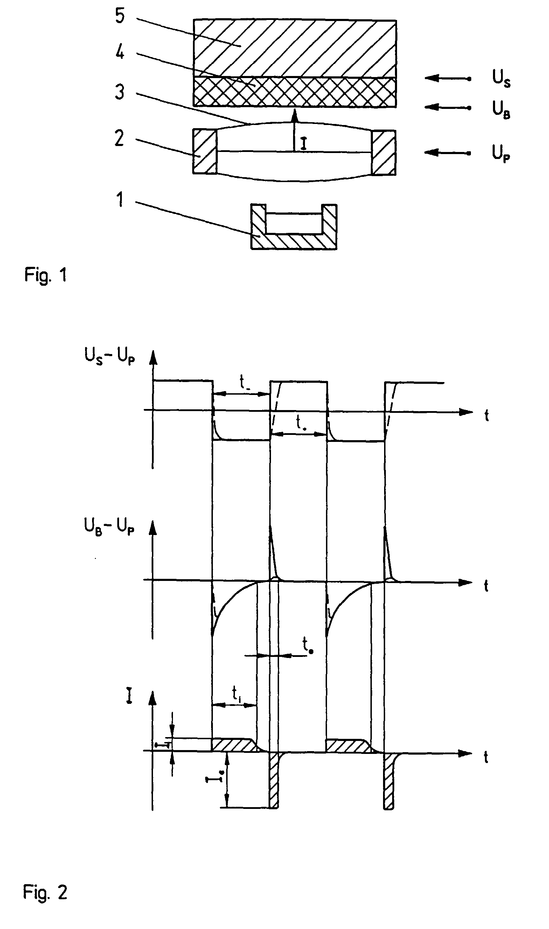

Fig. 1 zeigt eine Anordnung zur Durchführung des Verfahrens mit einer Beschichtungsquelle 1, einer Plasmaquelle 2, dem erzeugten Plasma 3, einer isolierenden Schicht 4 und einem leitfähigen Substrat 5. Über die isolierende Schicht 4 als Dielektrikum bildet sich ein Kondensator aus. Die obere Seite der isolierenden Schicht 4 lädt sich über das leitfähige Substrat 5 auf das Potential $U_S$ und die untere Seite der isolierenden Schicht 4 lädt sich über das Plasma 3 auf das Potential $U_B$ auf. Dabei fließt aus dem Plasma 3 der Strom I auf die untere Seite der isolierenden Schicht 4. Wegen des direkten Kontaktes zwischen dem leitfähigen Substrat 5 und der isolierenden Schicht 4 stimmt $U_S$ mit dem Potential des leitfähigen Substrates 5 überein, während sich das Potential $U_B$ vom Potential $U_P$ des Plasmas an der Unterseite der isolierenden Schicht 4 unterscheidet.

In Fig. 2 ist der prinzipielle zeitliche Verlauf der Potentiale $U_S$ und $U_B$ relativ zum Plasmapotential $U_P$ sowie der Verlauf des Stromes I, wenn an das leitfähige Substrat 5 abwechselnd während der Zeit $t_+$ eine positive und während der Zeit $t_-$ eine negative Spannung gelegt wird, dargestellt. Das Potential $U_S$ folgt unmittelbar der an das leitfähige Substrat 5 angelegten Spannung. Dagegen folgt das Potential $U_B$ infolge der Kondensatorwirkung der isolierenden Schicht 4 zwar den schnellen Spannungssprüngen, fällt dann aber infolge des Ladungsträgerstroms $I_B$ aus dem Plasma 3 sehr schnell bis annähernd auf das Plasmapotential $U_P$ ab. Dieser Abfall des Potentials $U_B$ erfolgt umso schneller, je höher der Strom I aus dem Plasma ist. Nach negativen Spannungssprüngen wird ein Strom $I_i$ positiver Ionen und nach positiven Spannungssprüngen ein Strom $I_e$ negativer Elektronen aus dem Plasma 3 auf die Oberfläche der isolierenden Schicht 4 gezogen. Wegen der höheren Beweglichkeit der Elektronen ist der negative Elektronenstrom $I_e$ deutlich höher als der positive Ionenstrom $I_i$. Entsprechend ist die Zeit $t_e$ zum Aufladen des Kondensators durch den Elektronenstrom $I_e$ kleiner als die Zeit $t_i$ zum Aufladen durch den Ionenstrom $I_i$. Da im zeitlichen Mittel keine Ladung von der isolierenden Oberfläche abfließen kann, gilt

$$I_i \cdot t_i = I_e \cdot t_e.$$

Um für eine effektive ionengestützte Beschichtung möglichst viele Ionen auf die Oberfläche der isolierenden Schicht 4 zu schießen, ist es zweckmäßig, die Zeitdauer $t_-$ und $t_+$ der Spannungsimpulse an die Aufladezeiten $t_i$ und $t_e$ des durch die isolierende Schicht 4 gebildeten Kondensators anzupassen:

$$t_- \approx t_i \; ; \; t_+ \approx t_e$$

Darüber hinaus ist es zweckmäßig (in Fig. 2 als unterbrochene Linie gezeichnet), daß die negativen Spannungsänderungen von $U_S$ wesentlich schneller erfolgen als die Aufladezeit $t_i$ der isolierenden Schicht 4 durch positive Ionen und daß die positiven Spannungsänderungen von $U_S$ höchstens genauso schnell oder langsamer erfolgen als die Aufladezeit $t_e$ der isolierenden Schicht 4 durch Elektronen. Dadurch wird erreicht, daß die Höhe der negativen Spannungsimpulse $U_B$ an der Unterseite der isolierenden Schicht 4, die als Bias-Spannung für die aus dem Plasma 3 extrahierten Ionen dient, nur unwesentlich verringert wird. Dagegen führt der relativ langsame Anstieg der positiven Impulse dazu, daß der Spannungsabfall durch die angesaugten Elektronen genauso schnell oder schneller erfolgt als der vom leitfähigen Substrat 5 influenzierte Spannungsanstieg. Das Ergebnis ist, daß sich das positive Potential $U_B$ an der Unterseite der isolierenden Schicht 4 nicht nennenswert über das Plasmapotential $U_P$ erhöht, so daß die aus dem Plasma 3 abgesaugten Elektronen keine unzulässig hohe Energie auf die Schicht 4 und das Substrat 5 übertragen. Das ist besonders wichtig bei der Beschichtung temperaturempfindlicher Substrate 5 wie z. B. Kunststoffolien.

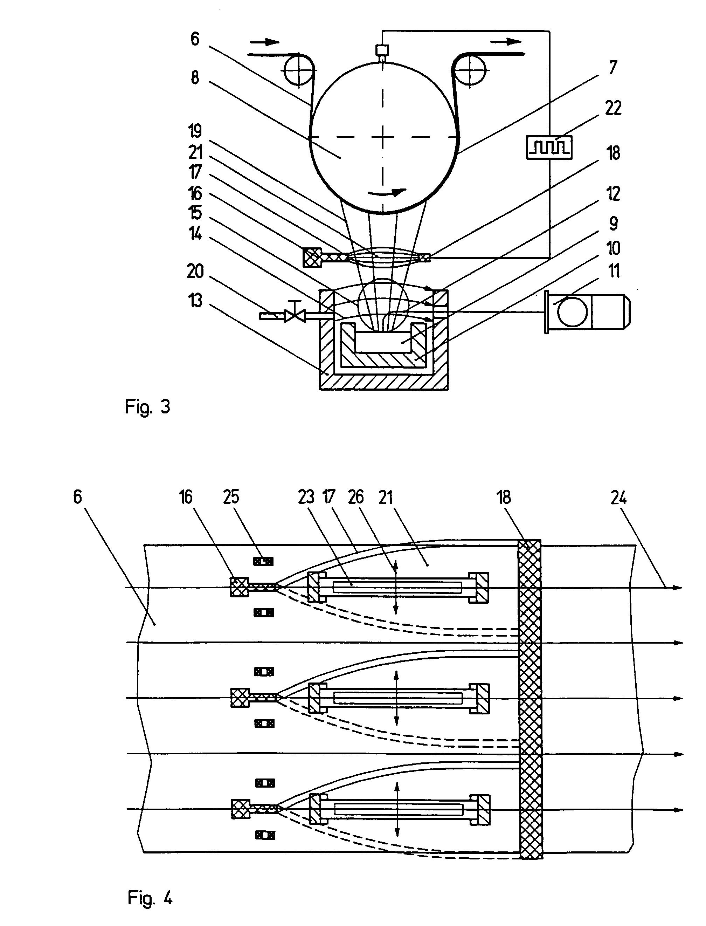

Fig. 3 zeigt eine Einrichtung zur Durchführung des Verfahrens für die Beschichtung von Kunststoffolien durch ionengestütztes Elektronenstrahlverdampfen von Aluminiumoxid. Eine 10 μm dicke elektrisch isolierende Kunststoffolie 6 (Polyesterfolie) wird mit einer 0,05 μm dicken elektrisch isolierenden Oxidschicht 7 bedampft, während sie in bekannter Weise im Vakuum über eine auf etwa -20 °C gekühlte Kühlwalze 8 geführt wird. Das Aluminiumoxid 9 wird aus einem wassergekühlten Tiegel 10 durch einen in einer Elektronenkanone 11 erzeugten Elektronenstrahl 12 verdampft. Die am Aluminiumoxid 9 rückgestreuten Elektronen werden durch ein in einer Magnetfalle 13 erzeugtes Magnetfeld 14 umgelenkt und damit am Auftreffen und am Aufheizen von Oxidschicht 7 und Kunststoffolie 6 gehindert. Durch die ionisierende Wirkung dieser rückgestreuten Elektronen entsteht ein Plasma 15 geringerer Dichte zwischen dem Tiegel 10 und der zu bedampfenden Kunststoffolie 6. Für das Erzeugen höherer Plasmadichten ist oberhalb der Magnetfalle 13 eine Katode 16 einer Hohlkatoden-Bogenquelle angeordnet. Der dadurch erzeugte Niedervolt-Elektronenstrahl 17 wird durch die Randfeldlinien des Magnetfeldes 14 zur Anode 18 der Hohlkatoden-Bogenquelle geführt. Durch den Niedervolt-Elektronenstrahl 17 wird der Dampfstrom 19 des verdampften Aluminiumoxids und der über ein Gaseinlaßsystem 20 eingelassene Sauerstoff angeregt, ionisiert und dissoziiert, so daß unterhalb der zu bedampfenden Kunststoffolie 6 ein hochdichtes Plasma 21 entsteht. Zwischen der annähernd auf Plasmapotential befindlichen Anode 18 und der gegen Massepotential isolierten Kühlwalze 8, als eine unmittelbar hinter der isolierenden Kunststoffolie 6 wirkende Elektrode, ist eine Spannungsquelle 22 zur Erzeugung rechteckförmiger Spannungsimpulse wechselnder Polarität angeordnet. Während der negativen Impulse von ca. 200 V Höhe und ca 20 μs Dauer werden Ionen aus dem hochdichten Plasma 21 zusätzlich zu den im Plasma teilweise ionisierten und angeregten Dampf- und Sauerstoffatomen auf die Kunststoffolie 6 bzw. die aufwachsende Oxidschicht 7 beschleunigt. Während der unmittelbar anschließenden positiven Impulse von ebenfalls ca. 200 V Höhe, aber nur ca. 5 μs Dauer, werden Elektronen aus dem hochdichten Plasma 21 auf die Kunststoffolie 6 bzw. die Oxidschicht 7 beschleunigt. Die auf diese Weise abgeschiedene Aluminiumoxidschicht weist eine hohe optische Transparenz und eine hohe Packungsdichte auf und eignet sich besonders als Barriereschicht für hochwertige Verpackungsfolien.

Fig. 4 zeigt als Draufsicht den Ausschnitt einer Einrichtung zur Durchführung des Verfahrens für die ionengestützte Beschichtung von Kunststoffolien mit Aluminiumoxid durch reaktives Verdampfen von Aluminium. Als Beschichtungsquelle dient eine Reihe von nebeneinander angeordneten wechselstrombeheizten Schiffchenverdampfern 23, die in Transportrichtung der Kunst- stoffolie 6 ausgerichtet sind. (Zur Beschichtung 1,50 m breiter Folien sind ca. 15 Schiffchenverdampfer nebeneinander angeordnet.) Für die Erzeugung eines hochdichten Plasmas 21 zwischen den Schiffchenverdampfern 23 und der Kunststoffolie 6 sind wiederum Hohlkatoden-Bogenquellen, bestehend aus Hohlkatoden 16 und einer gemeinsamen Anode 18, angeordnet. Die an den Hohlkatoden 16 erzeugten Niedervolt-Elektronenstrahlen 17 werden durch ein in Transportrichtung der Kunststoffolie 6 verlaufendes Magnetfeld 24 geführt und durch das Ablenksystem 25 in der Nähe der Hohlkatoden 16 quer zur Transportrichtung der Kunststoffolie 6 abgelenkt, um eine gleichmäßige Verteilung des Plasmas über die gesamte Breite der Kunststoffolie 6 zu erzielen. Zusätzlich erzeugen die Wechselströme zur Beheizung der Schiffchenverdampfer 23 ringförmig um die Schiffchenverdampfer 23 laufende magnetische Wechsel felder 26, die sich der Feldstärke des Magnetfeldes 24 überlagern und resultierend zu einer zusätzlichen seitlichen Ablenkung der Niedervolt-Elektronenstrahlen 17 und somit zu einer weiteren Homogenisierung des Plasmas 21 führen. Zwischen der etwa auf Plasmapotential befindlichen Anode 18 und der nicht dargestellten, aber analog zu Fig. 3 zur Führung der Kunststoffolie 6 oberhalb der Beschichtungsquelle angeordneten Kühlwalze 8 werden, ebenfalls analog zu Fig 3, Spannungsimpulse wechselnder Polarität angelegt, um abwechselnd Ionen und Elektronen aus dem Plasma auf die aufwachsende Schicht 7 zu schießen.

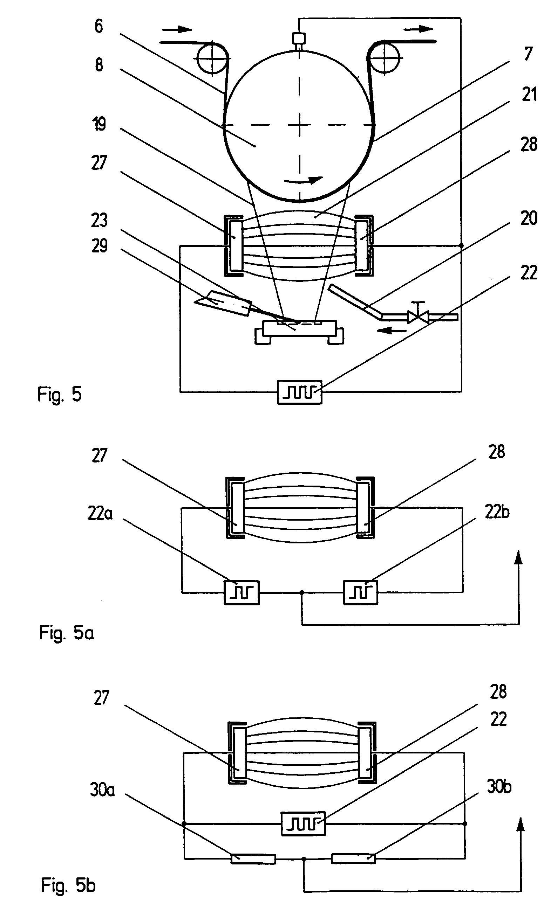

Fig. 5 zeigt eine weitere Einrichtung zur Durchführung des Verfahrens, ebenfalls mit Schiffchenverdampfern 23 als Beschichtungsquelle, aber mit zwei impulsförmig betriebenen Magnetrons 27, 28 zur Erzeugung des Plasmas 21 für die ionengestützte Beschichtung. Durch die Spannungsquelle 22 wird mit zeitlich abwechselnder Polarität jeweils ein Magnetron 27 auf negatives Potential (Katode) und ein Magnetron 28 auf positives Potential (Anode) gelegt. Eines der beiden Magnetrons 27; 28, beispielsweise das Magnetron 28, wird mit der hinter der Kunststoffolie 6 angeordneten, gegen Massepotential isolierten Kühlwalze 8 verbunden. Dadurch werden zeitlich abwechselnd bei negativem Potential des Magnetrons 28 gegenüber dem Magnetron 27 Ionen und bei positivem Potential des Magnetrons 28 gegenüber dem Magnetron 27 Elektronen aus dem Plasma 21 auf die auf der Kunststoffolie 6 aufwachsende Schicht 7 beschleunigt. Auf diese Weise wird beim Betrieb der beiden Magnetrons 27, 28 in Edelgas ohne Reaktivgasanteil eine reine Metallschicht mit hoher Packungsdichte und geringem elektrischen Widerstand abgeschieden. Mit Hilfe der Drahtzuführeinrichtung 29 und bei Verwendung entsprechend geeigneter Schiffchenverdampfer 23 können nahezu alle in Drahtform verfügbaren Metalle einschließlich Metallegierungen aufgedampft werden. Bei zusätzlichem Einlaß eines Reaktivgases, z. B. Sauerstoff, über das Gaseinlaßsystem 20 können auch die entsprechenden Metallverbindungen, z. B. Metalloxide, abgeschieden werden. Infolge der Aktivierung von Dampfstrom 19 und eingelassenem Reaktivgas beim Hindurchtreten durch das Plasma 21 werden auch bei hohen Beschichtungsraten stöchiometrische Schichten abgeschieden. Weiterhin wird durch das impulsförmige Ionenbombardement eine besonders dichte und fehlstellenarme Schicht erzielt, die als Barriereschicht für Verpackungsfolien oder als Korrosions- bzw. Abriebschutzschicht für das Substrat oder für eine bereits vorher auf das Substrat aufgebrachte Schicht geeignet ist. Darüber hinaus kann durch die hohe Gleichmäßigkeit des durch die Magnetrons 27, 28 erzeugten Plasmas 21 und der nahezu beliebigen Länge der Magnetrons 27, 28 eine hohe Konstanz der Schichteigenschaften auch über Beschichtungsbreiten von mehreren Metern erzielt werden.

In Fig. 5a ist eine Variante der in Fig. 5 gezeigten Einrichtung dargestellt, bei der für die Erregung der beiden Magnetrons 27, 28 zwei in Reihe geschaltete, synchron und gleichsinnig arbeitende Spannungsquellen 22a und 22b verwendet sind. In diesem Fall erfolgt der Spannungsabgriff für das elektrisch leitfähige Substrat bzw. die gemäß Fig. 5 verwendete, gegen Massepotential isolierte Kühlwalze 8 an der Verbindungsstelle zwischen den beiden Spannungsquellen 22a und 22b. Der Vorteil gegenüber der Einrichtung gemäß Fig. 5 besteht darin, daß während jeder Entladungsrichtung der beiden Magnetrons 27, 28 einmal Ionen und einmal Elektronen aus dem Plasma auf die Kunststoffolie 6 beschleunigt werden, während bei der Einrichtung gemäß Fig. 5 in einer Entladungsrichtung nur Ionen und in der anderen Entladungsrichtung nur Elektronen abgesaugt werden. Allerdings steht bei gleicher Puls-Spannung zwischen den Magnetrons 27, 28 nur die halbe Puls-Spannung zwischen der Kunststoffolie 6 und dem Plasma zur Verfügung.

Mit der Variante gemäß Fig. 5b werden die gleichen Eigenschaften wie mit der Variante nach Fig. 5a erreicht. Durch einen Spannungsteiler aus zwei gleichgroßen elektrischen Widerständen 30a und 30b über der Spannungsquelle 22, dessen Mittelabgriff mit dem Substrat bzw. mit der gemäß Fig. 5 verwendeten Kühlwalze 8 verbunden ist, wird im Vergleich zur Variante nach 5a nur eine Spannungsquelle 22 benötigt. Allerdings wird je nach erforderlichem Puls-Bias-Strom für den Spannungsteiler aus den Widerständen 30a und 30b ein zusätzlicher Strom benötigt, so daß im Vergleich zu den Varianten nach Fig. 5 und Fig. 5a eine Spannungsquelle 22 mit höherer Stromergiebigkeit erforderlich ist.

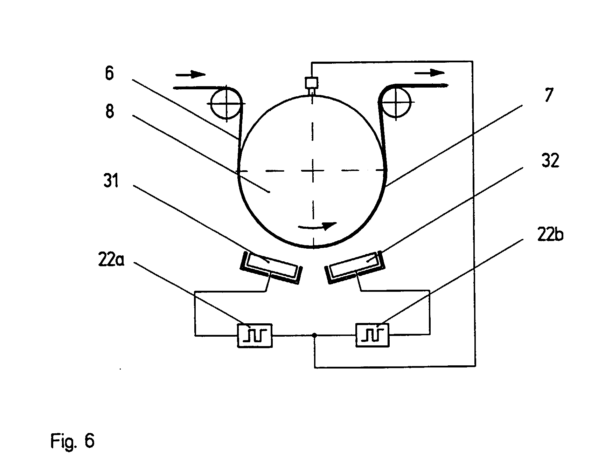

Fig. 6 zeigt eine Einrichtung zur Durchführung des Verfahrens bei Verwendung von Sputterquellen als Beschichtungsquelle. Von der Vielzahl der möglichen Varianten bezüglich der Art und der Anzahl der Sputterquellen wird das Beschichten mittels zweier Magnetron-Zerstäubungsquellen 31; 32 dargestellt. Es ist bekannt, daß insbesondere zum Abscheiden hochisolierender, fehlstellenarmer Schichten das Puls-Sputtern dem reaktiven Gleichspannungs- oder dem Hochfrequenz-Sputtern überlegen ist. Eine weitere Verbesserung der Schichteigenschaften, insbesondere der Packungsdichte der Schichten, ist durch zusätzliche Anwendung des erfindungsgemäßen Verfahrens möglich. Das ist besonders vorteilhaft, denn es kann sowohl die Spannungsquelle 22a; 22b der Magnetron-Zerstäubungsquellen 31; 32 als auch das beim Sputtern ohnehin erzeugte Plasma zur Durchführung des Verfahrens genutzt werden. Die Ankopplung des Substrates bzw. der für die Beschichtung von Kunststoffolien 6 verwendeten Kühlwalze 8 an die Spannungsquelle 22 a; 22 b entspricht der Ankopplung, wie sie in Fig. 5a für die Nutzung von Magnetrons als Plasmaquelle dargestellt wurde. Die in Fig. 5b dargestellte Variante wäre ebenfalls nutzbar, während die in Fig. 5 gezeigte Variante wegen der Unsymmetrie der beiden Magnetrons weniger gut geeignet ist.

**Patentansprüche**

1. Verfahren für die ionengestützte Vakuumbeschichtung, vorzugsweise für die Hochratebeschichtung großflächiger elektrisch leitfähiger oder elektrisch isolierender Substrate (5; 6) mit elektrisch isolierenden Schichten (4) und elektrisch isolierender Substrate (6) mit elektrisch leitenden Schichten, indem zwischen einer Beschichtungsquelle und dem Substrat (5; 6) ein Plasma (21) erzeugt wird, aus welchem Ionen in Richtung auf das Substrat (5; 6) beschleunigt werden, **dadurch gekennzeichnet**, daß an das elektrisch leitfähige Substrat (5) oder an eine unmittelbar hinter dem elektrisch isolierenden Substrat (6) angeordnete, sich über die gesamte Beschichtungsfläche erstreckende Elektrode (8) abwechselnd negative und positive Spannungsimpulse relativ zum Plasma (21) angelegt werden, daß die Dauer der negativen Impulse der Aufladezeit des sich über die isolierende Schicht (4) und/oder das isolierende Substrat (6) ausbildenden Kondensators angepaßt wird, daß die Dauer der positiven Impulse höchstens gleich, vorzugsweise 2- bis 10mal kleiner als die Dauer der negativen Impulse gewählt wird, daß die positiven und negativen Impulse unmittelbar aneinander anschließen und annähernd auf die gleiche Höhe relativ zum Plasmapotential eingestellt werden und daß die Hohe der Impulse relativ zum Plasmapotential $\pm$ 20 bis $\pm$ 2000 V, vorzugsweise $\pm$ 50 bis $\pm$ 500 V eingestellt wird.

2. Verfahren nach Anspruch 1, **dadurch gekennzeichnet**, daß die Dauer der negativen Impulse bei isolierenden Schicht- und/oder Substratdicken von 1 µm bis 100 µm auf etwa 1 ms bis 10 µs eingestellt wird.

3. Verfahren nach Anspruch 1 und 2, **dadurch gekennzeichnet**, daß an das leitfähige Substrat (5) oder die Elektrode (8) rechteckförmige Spannungsimpulse angelegt werden, daß die Anstiegszeit der positiven und die Abfallzeit der negativen Impulse so groß gewählt wird, daß das Oberflächenpotential der abgeschiedenen Schicht (4) zu keinem Zeitpunkt mehr als 20 V positiv gegenüber dem Plasmapotential angehoben wird, während die Anstiegszeit der negativen und die Abfallzeit der positiven Impulse so gering gewählt wird, daß das Oberflächenpotential der abgeschiedenen Schicht (4) kurzzeitig auf einen negativen Wert von mindestens 50 Prozent der doppelten Impulshöhe gegenüber dem Plasmapotential angehoben wird.

4. Verfahren nach Anspruch 1 und 2, **dadurch gekennzeichnet**, daß an das leitfähige Substrat (5) oder die Elektrode (8) sinusförmige Spannungsimpulse angelegt werden und die Dauer der positiven und negativen Impulse gleich lang eingestellt wird.

5. Verfahren nach Anspruch 1 bis 4, **dadurch gekennzeichnet**, daß bei Verwendung eines Elektronenstrahlverdampfers als Beschichtungssquelle das Plasma (21) durch Ionisierung von Dampf und Restgas mit Hilfe des Elektronenstrahls (12) und der am Verdampfungsgut (9) rückgestreuten Elektronen erzeugt wird.

6. Verfahren nach Anspruch 1 bis 4, **dadurch gekennzeichnet**, daß bei Verwendung von beliebig beheizten Verdampfern als Beschichtungsquelle das Plasma (21) durch zusätzliche Niedervolt-Bogenentladungen im Bereich zwischen Verdampfer und Substrat (5; 6) erzeugt wird.

7. Verfahren nach Anspruch 6, **dadurch gekennzeichnet**, daß bei Verwendung von widerstandsbeheizten Schiffchenverdampfern (23) als Beschichtungsquelle das Plasma (21) durch Hohlkatoden-Bogenentladungen im Bereich zwischen den Verdampfern (23) und dem Substrat (5; 6) erzeugt wird.

8. Verfahren nach Anspruch 1 bis 4, **dadurch gekennzeichnet**, daß bei Verwendung beliebig beheizter Verdampfer als Beschichtungsquelle das Plasma (21) durch eine Magnetronentladung, vorzugsweise zwischen zwei mit zeitlich wechselnder Polarität gegeneinander brennenden Magnetrons (27; 28), erzeugt wird.

9. Verfahren nach Anspruch 1 bis 4, **dadurch gekennzeichnet**, daß bei Verwendung einer oder mehrerer Zerstäubungsquellen (31; 32) als alleinige oder als zusätzliche Beschichtungsquelle diese Zerstäubungsquellen (31; 32) gleichzeitig zur Erzeugung des Plasmas (21) verwendet werden.

10. Einrichtung zur Durchführung des Verfahrens nach Anspruch 1, bestehend aus mindestens einer Beschichtungsquelle, einer Vorrichtung zur Substrathalterung bzw. -führung, Mitteln zur Erzeugung eines Plasmas und einer Spannungsquelle (22) zur Erzeugung von Spannungsimpulsen, **dadurch gekennzeichnet**, daß an das elektrisch leitfähige Substrat (5) oder an eine unmittelbar hinter dem elektrisch isolierenden Substrat (6) angeordnete Elektrode (8) ein Pol der Spannungsquelle (22), die Spannungsimpulse wechselnder Polarität mit Impulshöhen zwischen ± 20 V und ± 2000 V und Impulsdauern zwischen 1 µs und 1000 µs erzeugt, angeschlossen ist, und daß der andere Pol der Spannungsquelle (22) an einen Pol der Einrichtung zur Erzeugung des Plasmas, die eine auf annähernd Plasmapotential befindliche Elektrode (13; 27; 28; 31; 32) ist, angeschlossen ist.

11. Einrichtung nach Anspruch 10, **dadurch gekennzeichnet**, daß bei der Beschichtung bandförmiger, elektrisch isolierender Substrate (6) die Elektrode eine Kühlwalze (8) ist, die gegen Massepotential isoliert ist.

12. Einrichtung nach Anspruch 10 und 11, **dadurch gekennzeichnet**, daß bei Verwendung eines Elektronenstrahlverdampfers als Beschichtungsquelle zwischen dem Verdampfungsgut (9) und dem Substrat (6) eine an sich bekannte Magnetfalle (13) zum Umlenken der rückgestreuten Elektronen vorgesehen ist und daß die Polschuhe der Magnetfalle (13) ein Pol der Einrichtung zur Erzeugung des Plasmas sind.

13. Einrichtung nach Anspruch 10 bis 12, **dadurch gekennzeichnet**, daß zwischen der Beschichtungsquelle und dem Substrat (6) Niedervolt-Bogenquellen, vorzugsweise Hohlkatoden-Bogenquellen, angeordnet sind und daß die Anoden (18) dieser Bogenquellen ein Pol der Einrichtung zur Erzeugung des Plasmas sind.

14. Einrichtung nach Anspruch 13, **dadurch gekennzeichnet**, daß für die Beschichtung bewegter Substrate (6) als Beschichtungsquelle mehrere wechselstrombeheizte Schiffchenverdampfer (23), deren Längsrichtung mit der Transportrichtung des Substrates (6) übereinstimmt, nebeneinander angeordnet sind, und daß oberhalb eines jeden Schiffchenverdampfers (23) oder oberhalb einer Gruppe von mehreren Schiffchenverdampfern (23) jeweils eine Hohlkatoden-Bogenquelle, deren Hohlkatodenbogen im wesentlichen in Schiffchenlängsrichtung verläuft, angeordnet sind.

15. Einrichtung nach Anspruch 14, **dadurch gekennzeichnet**, daß an jeder Hohlkatoden-Bogenquelle ein an sich bekanntes magnetisches Ablenksystem (25) für die horizontale Wechselablenkung der Hohlkatodenbögen angeordnet ist.

16. Einrichtung nach Anspruch 10 bis 12, **dadurch gekennzeichnet**, daß zur Erzeugung eines Plasmas (21) zwei gegen Massepotential isolierte und mit zeitlich wechselnder Polarität gegeneinander brennende Magnetrons (27; 28) zwischen der Beschichtungsquelle und dem Substrat (6) angeordnet sind und daß die Spannungsquelle (22) für die beiden Magnetrons (27; 28) gleichzeitig Spannungsquelle für die Erzeugung der Spannungsimpulse am Substrat (6) ist.

17. Einrichtung nach Anspruch 16, **dadurch gekennzeichnet**, daß eines der beiden Magnetrons (27; 28) mit dem elektrisch leitfähigen Substrat (5) oder mit der unmittelbar hinter dem elektrisch isolierenden Substrat (6) befindlichen Elektrode (8) verbunden ist.

18. Einrichtung nach Anspruch 16, **dadurch gekennzeichnet**, daß die Spannungsquelle (22) für die beiden Magnetrons (27; 28) aus zwei in Reihe geschalteten, synchron und gleichsinnig arbeitenden Spannungsquellen (22a; 22b) besteht und zwischen beiden ein Spannungsabgriff vorhanden ist, der mit dem elektrisch leitfähigen Substrat (5) oder mit der unmittelbar hinter dem elektrisch isolierenden Substrat (6) befindlichen Elektrode (8) verbunden ist.

19. Einrichtung nach Anspruch 16, **dadurch gekennzeichnet**, daß die beiden Ausgänge der Spannungsquelle (22) für die Magnetrons (27; 28) über gleichgroße elektrische Widerstände (30a; 30b) mit dem elektrisch leitfähigen Substrat (5) oder mit der unmittelbar hinter dem elektrisch isolierenden Substrat (6) angeordneten Elektrode (8) verbunden sind.

20. Einrichtung nach Anspruch 10 bis 12, **dadurch gekennzeichnet**, daß als alleinige oder zusätzliche Beschichtungsquelle sowie zur gleichzeitigen Erzeugung eines Plasmas (21) eine oder mehrere Magnetron-Zerstäubungsquellen (31; 32) angeordnet sind.

21. Einrichtung nach Anspruch 20, **dadurch gekennzeichnet**, daß die Magnetron-Zerstäubungsquellen (31; 32) reaktiv betriebene Gleichstrom-Magnetrons oder Hochfrequenz-Magnetrons sind.

22. Einrichtung nach Anspruch 20, **dadurch gekennzeichnet**, daß die Magnetron-Zerstäubungsquellen (31; 32) zwei mit wechselnder Polarität gegeneinander brennende Magnetrons sind und daß die Spannungsquelle (22) für die Magnetron-Zerstäubungsquellen (31; 32) gleichzeitig die Spannungsquelle zur Erzeugung der Spannungsimpulse am Substrat (6) ist.

**Claims**

1. Process for ion-supported vacuum coating, preferably for high-rate coating of large-surface electrically conductive or nonconducting substrates (5;6) with electrically insulating layers (4) and of electrically insulating substrates (6) with electrically conductive layers, there being produced between a coating source and the substrate (5;6) a plasma (21) from which ions are accelerated in the direction of the substrate (5;6), **characterised in that** alternately negative and positive voltage pulses relative to the plasma (21) are passed to the electrically conductive substrate (5) or to an electrode (8) arranged directly behind the electrically insulating substrate (6) and extending over the whole coating surface, in that the duration of the negative pulses is adapted to the charging time of the condenser forming over the insulating layer (4) and/or the insulating substrate (6), in that the duration of the positive pulses is selected to be at the most the same, preferably twice to 10 times smaller than the duration of the negative pulses, in that the positive and negative pulses follow one another immediately and are set at approximately the same amplitude relative to the plasma potential, and in that the amplitude of the pulses relative to the plasma potential is set at ± 20 to ± 2000 V, preferably ± 50 to 500 V.

2. Process according to claim 1, **characterised in that** the duration of the negative pulses for insulating layer and/or substrate thicknesses of 1 µm to 100 µm is set at approximately 1 ms to 10 µs.

3. Process according to claim 1 and 2, **characterised in that** rectangular voltage pulses are applied to the conductive substrate (5) or the electrode (8), in that the rise time of the positive pulses and the fall time of the negative pulses is selected to be of such size that the surface potential of the layer (4) deposited is at no time raised more than 20 V positively in relation to the plasma potential, whilst the rise time of the negative pulses and the fall time of the positive pulses is chosen to be so small that the surface potential of the layer (4) deposited is briefly raised to a negative value of at least 50 percent of twice the pulse amplitude in relation to the plasma potential.

4. Process according to claim 1 and 2, **characterised in that** sinusoidal voltage pulses are applied to the conductive substrate (5) or the electrode (8), and the duration of the positive and negative pulses is set to be of equal length.

5. Process according to claim 1 to 4, **characterised in that** when an electron-beam vaporizer is used as coating source, the plasma (21) is produced by ionization of vapour and residual gas with the aid of the electron beam (12) and of the electrons backscattered on the vaporization material (9).

6. Process according to claim 1 to 4, **characterised in that**, when any heated vaporizers are used as coating source, the plasma (21) is produced by additional low voltage arc discharges in the region between vaporizer and substrate (5; 6).

7. Process according to claim 6, **characterised in that**, when resistance heated boat vaporizer (23) are used as coating source, the plasma (21) is produced by hollow cathode arc discharges in the region between the vaporizers (23) and the substrate (5; 6).

8. Process according to claim 1 to 4, **characterised in that**, when any heated vaporizers are used as coating source, the plasma (21) is produced by a magnetron discharge, preferably between two magnetrons (27; 28) firing against one another with polarity alternating in time.

9. Process according to claim 1 to 4, **characterised in that**, when one or a plurality of sputtering sources (31; 32) are used as sole or additional coating source, these sputtering sources (31; 32) are simultaneously used to produce the plasma (21).

10. Device for carrying out the process according to claim 1, comprising at least one coating source, one device for holding or guiding the substrate, means for producing a plasma and a voltage source (22) for generating voltage pulses, **characterised in**

**that** one pole of the voltage source (22), which generates voltage pulses of alternating polarity with pulse amplitudes between ± 20 V and ± 2000 V, is connected to the electrically conductive substrate (5) or to an electrode (8) arranged directly behind the electrically insulating layer (6), and in that the other pole of the voltage source (22) is connected to a pole of the device for producing the plasma, which device is an electrode (13; 27; 28; 31; 32) at approximately plasma potential.

11. Device according to claim 10, **characterised in that** in the coating of band-shaped, electrically insulating substrates (6) the electrode is a cooling roller (8), which is insulated against earth potential.

12. Device according to claim 10 and 11, **characterised in that**, when an electron-beam vaporizer is used as coating source, there is provided between the vaporization material (9) and the substrate (6) a magnetic trap (13), which is in itself known, for deflecting the backscattered electrons, and in that the pole shoes of the magnetic trap (13) are one pole of the device for producing the plasma.

13. Device according to claim 10 to 12, **characterised in that** between the coating source and the substrate (6) there are arranged low voltage arc sources, preferably hollow cathode arc sources, and in that the anodes (18) of these arc sources are one pole of the device for producing the plasma.

14. Device according to claim 13, **characterised in that**, for the coating of moved substrates (6), a plurality of AC heated boat vaporizers (23), whose longitudinal direction corresponds with the transport direction of the substrate (6), are arranged beside one another, and in that, above each boat vaporizer (23), or above a group of a plurality of boat vaporizers (23), there is arranged in each case one hollow cathode arc source, whose hollow cathode arc runs essentially in the longitudinal direction of the boat.

15. Device according to claim 14, **characterised in that** there is arranged on each hollow cathode arc source a magnetic deflection system (25), which is in itself known, for the horizontal alternating deflection of the hollow cathode arcs.

16. Device according to claim 10 to 12, **characterised in that**, to produce a plasma (21), two magnetrons (27; 28), firing against one another, insulated against earth potential and with polarity alternating in time, are arranged between the coating source and the substrate (6), and in that the voltage source (22) for the two magnetrons (27; 28) is at the same time the voltage source for generating the voltage pulses on the substrate (6).

17. Device according to claim 16, **characterised in that** one of the two magnetrons (27; 28) is connected to the electrically conductive substrate (5) or to the electrode (8) located directly behind the electrically insulating substrate (6).

18. Device according to claim 16, **characterised in that** the voltage source (22) for the two magnetrons (27; 28) consists of two series-connected voltage sources (22a; 22b) working synchronously and in the same direction, and a voltage tap is present between the two which is connected with the electrically conductive substrate (5) or with the electrode (8) located directly behind the electrically insulating substrate (6).

19. Device according to claim 16, **characterised in that** the two outputs of the voltage source (22) for the magnetrons (27; 28) are connected via electrical resistances (30a; 30b) of the same size with the electrically conductive substrate (5) or with the electrode (8) arranged directly behind the electrically insulating substrate (6).

20. Device according to claim 10 to 12, **characterised in that** one or a plurality of magnetron sputtering sources (31; 32) are arranged as sole or additional coating source and for the simultaneous production of a plasma (21).

21. Device according to claim 20, **characterised in that** the magnetron sputtering sources (31; 32) are reactively operated DC magnetrons or high frequency magnetrons.

22. Device according to claim 20, **characterised in that** the magnetron sputtering sources (31; 32) are two magnetrons firing with alternating polarity against one another, and in that the voltage source (22) for the magnetron sputtering sources (31; 32) is at the same time the voltage source for generating the voltage pulses on the substrate (6).

**Revendications**

1. Procédé de revêtement sous vide par voie ionique de préférence pour le revêtement à vitesse élevée de substrats (5, 6) conducteurs électriques ou isolants électriques de grande surface, avec des couches (4) isolantes ou des substrats (6) isolants électriques avec des couches conductrices,

   - selon lequel, entre une source de revêtement et le substrat (5, 6), on génère un plasma (21) à partir duquel on accélère des ions en direction du substrat (5, 6),

caractérisé en ce qu'

- on applique des impulsions de tension positives et négatives alternées par rapport au plasma (21) au substrat conducteur électrique (5) ou à une électrode (8) s'étendant sur toute la surface de revêtement, derrière le substrat isolant électrique (6),
- on adapte la durée des impulsions négatives au temps de charge du condensateur formé avec la couche isolante (4) et/ou le substrat isolant (6),
- on choisit la durée des impulsions positives au maximum égale et de préférence de 2 à 10 fois inférieure à la durée des impulsions négatives,
- on règle les impulsions positives et négatives directement de façon adjacente et sensiblement à la même amplitude que le potentiel du plasma et
- on règle l'amplitude des impulsions par rapport au potentiel du plasma à ± 20 jusqu'à ± 2000 V et de préférence entre ± 50 et ± 500 V.

2. Procédé selon la revendication 1,
caractérisé en ce qu'
on règle la durée des impulsions négatives pour une épaisseur de couche isolante et/ou de substrat comprise entre 1 μm et 100 μm à environ 1 ms jusqu'à 10 μs.

3. Procédé selon les revendications 1 et 2,
caractérisé en ce qu'

- on applique des impulsions de tension rectangulaires au substrat conducteur (5) et aux électrodes (8),
- on choisit le temps de montée de l'impulsion positive et le temps de descente de l'impulsion négative suffisamment importants,
- on relève le potentiel de surface de la couche déposée (4) à aucun instant à plus de 20 V de manière positive par rapport au potentiel du plasma alors que le temps de montée de l'impulsion négative et le temps de descente de l'imposition positive sont choisis suffisamment faibles pour que le potentiel de surface de la couche déposée (4) soit relevé brièvement à une valeur négative d'au moins 50 % du double de l'amplitude impulsionnelle par rapport au potentiel du plasma.

4. Procédé selon les revendications 1 et 2,
caractérisé en ce qu'
on applique des impulsions de tension sinusoïdales au substrat conducteur (5) ou à l'électrode (8) et on règle la durée des impulsions positives et négatives pour qu'elles aient la même valeur.

5. Procédé selon l'une quelconque des revendications 1 à 4,
caractérisé en ce qu'
on utilise un évaporateur à faisceau d'électrons comme source de revêtement et on génère du plasma (21) par ionisation ou de la vapeur et du gaz résiduel à l'aide du faisceau d'électrons (12) et des électrons renvoyés par le produit d'évaporation (9).

6. Procédé selon l'une quelconque des revendications 1 à 4,
caractérisé en ce qu'
on utilise des évaporateurs chauffés de manière quelconque comme sources de revêtement, et on génère le plasma (21) par des décharges d'arc basse tension, complémentaires, dans la zone comprise entre l'évaporateur et le substrat (5, 6).

7. Procédé selon la revendication 6,
caractérisé en ce qu'
on utilise des navettes d'évaporation (23) chauffées par résistance comme sources de revêtement et on génère le plasma (21) par des décharges d'arc de cathodes creuses dans la zone comprise entre les évaporateurs (23) et le substrat (5, 6).

8. Procédé selon l'une quelconque des revendications 1 à 4,
caractérisé en ce qu'
on utilise un évaporateur chauffé de manière quelconque comme source de revêtement et on génère le plasma (21) par une décharge par magnétrons de préférence entre deux magnétrons (27, 28) actifs de façon opposée avec une polarité alternant dans le temps.

9. Procédé selon les revendications 1 à 4,
caractérisé en ce que
dans le cas d'une ou plusieurs sources de pulvérisation (31, 32), on utilise comme unique source de revêtement ou comme source de revêtement supplémentaire, ces sources de pulvérisation (31, 32) en même temps pour générer le plasma.

10. Installation pour la mise en oeuvre du procédé selon la revendication 1 composée d'au moins une source de revêtement, d'un dispositif pour tenir et guider le substrat, des moyens générant du plasma et une source de tension (22) pour générer des impulsions de tension,
caractérisée en ce qu'

on relie au substrat conducteur électrique (5) ou à une électrode (8) placée directement derrière le substrat isolant électrique (6), un pôle de la source de tension (22) qui génère des impulsions de tension de polarité alternée avec des amplitudes comprises entre ± 20 V et ± 2000 V et une durée d'impulsions comprise entre 1 µs et 1000 µs,
et l'autre pôle de la source de tension (22) est relié à un pôle de l'installation générant le plasma, qui est une électrode (13 ; 27 ; 28 ; 31 ; 32) à un potentiel voisin de celui du plasma.

11. Installation selon la revendication 10,
caractérisée en ce que
pour le revêtement de substrat (6) en forme de ruban, isolant électrique, l'électrode est un cylindre de refroidissement (8) isolé par rapport à la masse.

12. Installation selon les revendications 10 et 11,
caractérisée en ce que

dans le cas d'un évaporateur à faisceau d'électrons comme source de revêtement, entre le produit évaporé (9) et le substrat (6), on a un piège magnétique (13), pour dévier les électrons renvoyés et
la pièce polaire du piège magnétique (13) est constituée par un pôle de l'installation générant le plasma.

13. Installation selon l'une quelconque des revendications 10 à 12,
caractérisée en ce qu'

entre la source de revêtement et le substrat (6), on a des sources d'arcs électriques basse tension de préférence des sources d'arcs électriques à cathodes creuses et
les anodes (18) de ces sources d'arcs électriques sont constituées par un pôle de l'installation générant le plasma.

14. Installation selon la revendication 13,
caractérisée en ce que

- pour revêtir un substrat (6) en mouvement, la source de revêtement est constituée par plusieurs évaporateurs en forme de navettes (23) chauffées par un courant alternatif et dont la direction longitudinale correspond à la direction de transport du substrat (6), ces navettes étant juxtaposées, et
- au-dessus de chaque évaporateur à navettes (23) ou au-dessus d'un groupe de plusieurs évaporateurs à navettes (23), il y a chaque fois une source d'arc électrique à cathode creuse dont l'arc électrique est essentiellement dirigé dans le sens longitudinal des navettes.

15. Installation selon la revendication 14,
caractérisée en ce que
chaque source d'arcs électriques à cathodes creuses est reliée à un système de déflexion magnétique (25) connu en soi pour la déflexion horizontale alternée des arcs électriques de la cathode creuse.

16. Installation selon l'une quelconque des revendications 10 à 12,
caractérisée par

- deux magnétrons (27, 28) agissant en sens opposé pour générer un plasma (21), qui sont isolés par rapport au potentiel de la masse et reçoivent des polarités opposées dans le temps, ces magnétrons étant branchés entre la source de revêtement et le substrat (6), et
- la source de tension (22) pour les deux magnétrons (27, 28) est en même temps la source de tension générant les impulsions de tension du substrat (6).

17. Installation selon la revendication 16,
caractérisée en ce que
l'un des deux magnétrons (27, 28) est relié au substrat conducteur électrique (5) ou à une électrode (8) qui se trouve directement derrière le substrat isolant électrique (6).

18. Installation selon la revendication 16,
caractérisée en ce que
la source de tension (22) pour les deux magnétrons (27, 28) se compose de deux sources de tension (22a, 22b) branchées en série et fonctionnant en synchronisme mais dans le même sens et entre les deux sources il y a une prise de tension reliée au substrat conducteur électrique (5) ou à une électrode (8) directement derrière le substrat isolant électrique (6).

19. Installation selon la revendication 16,
caractérisée en ce que
les deux sorties de la source de tension (22) pour les magnétrons (27, 28) sont reliées par des résistances électriques (30a, 30b) de même valeur au substrat conducteur électrique (5) ou à une électrode (8) placée directement derrière le substrat isolant électrique (6).

20. Installation selon l'une quelconque des revendications 10 à 12,
caractérisée en ce qu'
une ou plusieurs sources de pulvérisation à magnétrons (31, 32) sont prévues comme sources d'alimentation uniques ou complémentaires ainsi que pour générer en même temps un plasma (21).

21. Installation selon la revendication 20,
caractérisée en ce que
les sources de pulvérisation à magnétron (31, 32) sont des magnétrons à courant continu à fonctionnement réactif ou des magnétrons à haute fréquence.

22. Installation selon la revendication 20,
caractérisée en ce que

les sources de pulvérisation de magnétron (31, 32) sont deux magnétrons travaillant l'un par rapport à l'autre avec une polarité opposée et la source de tension (22) des sources de pulvérisation à magnétrons (31, 32) sont en même temps les sources de tension générant les impulsions de tension sur le substrat (6).

Fig. 1

Fig. 2

Fig. 3

Fig. 4

Fig. 5

Fig. 5a

Fig. 5b

Fig. 6